# EUROPEAN PATENT APPLICATION

(11) **EP 4 517 479 A1**
(43) Date of publication of application: **05.03.2025**
(21) Application number: 23306434.4
(22) Date of filing: 30.08.2023
(51) Int. Cl.: G06F 1/18, H05K 7/20, H01H 37/52

(54) **DATACENTER TEMPERATURE MONITORING SYSTEM FOR LIQUID-COOLED RACK-MOUNTED ASSEMBLIES**

(71) Applicant: OVH, 59100 Roubaix (FR)
(72) Inventor: THIBAUT, Christophe Maurice, 59139 Noyelles les seclin (FR)
(74) Representative: BCF Global

(57) **Abstract**

A datacenter temperature monitoring system and method for rack-mounted assemblies. The temperature monitoring system includes a power distribution unit configured to distribute power to each of the rack-mounted assemblies and a thermostatic unit electrically connected to the power distribution unit and configured to detect a temperature of one or more of the rack-mounted assemblies, wherein, in response to the thermostatic unit detecting a temperature of one of the rack-mounted assemblies that exceeds a high temperature threshold, the thermostatic unit causes the corresponding rack-mounted assembly to disconnect from the PDU.

## Description

### FIELD OF TECHNOLOGY

The present technology relates to a temperature monitoring system for datacenter rack-mounted processing assemblies. In particular, the present technology relates to a temperature monitoring system that monitors the temperature of a datacenter rack-mounted assembly and interrupts the power supplied to the rack-mounted assembly in the event of detecting overheating temperatures.

### BACKGROUND

Electronic equipment, for example processing servers, memory banks, computer disks, and the like, are conventionally arranged in electronic equipment racks. Large datacenters as well as other large computing facilities may contain thousands of racks supporting thousands or even tens of thousands of processing servers. These electronic equipment racks typically consume large amounts of electrical power and generate significant amounts of heat. Some electronic devices, such as processors, generate so much heat that they could fail within seconds due to overheating.

As such, cooling measures are employed to control the heat generated by such electronic equipment. One such cooling measure, direct liquid cooling blocks, in particular water cooling, has been used as an addition or replacement to traditional forced-air cooling. Cold plates, for example water blocks having internal channels for channelized water circulation, may be mounted on heat-generating components, such as processors, to displace heat from the processors toward heat exchangers. Additionally, immersion cooling (sometimes called immersive cooling) has also been employed. That is, electronic components are inserted in a container that is fully or partially filled with a non-conducting cooling liquid, for example an oil-based dielectric cooling liquid. Efficient thermal contact is obtained between the electronic components and the dielectric cooling liquid. Immersion cooling systems commonly take the form of large tanks in which the electronic devices are submerged. In even other cooling measures, hybrid cooling systems that involve both water cooling and immersion cooling techniques have been employed to increase the cooling effectiveness of heat generating electronic components.

However, such liquid cooling systems may be prone to certain malfunctions, such as, for example, water block failures, dielectric cooling liquid leakages, etc. As such, temperature monitoring systems for liquid-cooled electronic devices are currently being designed.

Existing cooling monitoring systems for liquid-cooled electronic devices typically require numerous sensors and controllers with corresponding wiring that limits the utilization of racks and adds to operating costs. Therefore, there is an interest in developing alternative low cost, independently-addressable temperature monitoring systems without complicated sensors and controllers that are capable of providing sufficient protection in the event of overheating occurrences.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

### TBD UPON FINALIZATION OF CLAIMS.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects, and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
Figure 1 depicts a perspective view of a datacenter rack system housing numerous rack-mounted assemblies with a temperature monitoring system, in accordance with the embodiments of the present disclosure;
Figure 2 depicts a perspective view of a rack-mounted assembly with a temperature monitoring system, in accordance with the embodiments of the present disclosure;
Figure 3A depicts a side view of an exemplary temperature monitoring system of rack-mounted assemblies, in accordance with the embodiments of the present disclosure;
Figure 3B depicts a perspective view of an exemplary temperature monitoring system of rack-mounted assemblies, in accordance with the embodiments of the present disclosure; and
Figure 4 depicts a functional block diagram of the electrical connections of the temperature monitoring system relative to the electronic components hosted by rack-mounted assemblies, in accordance with the embodiments of the present disclosure.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate various implementations of aspects of the present disclosure.

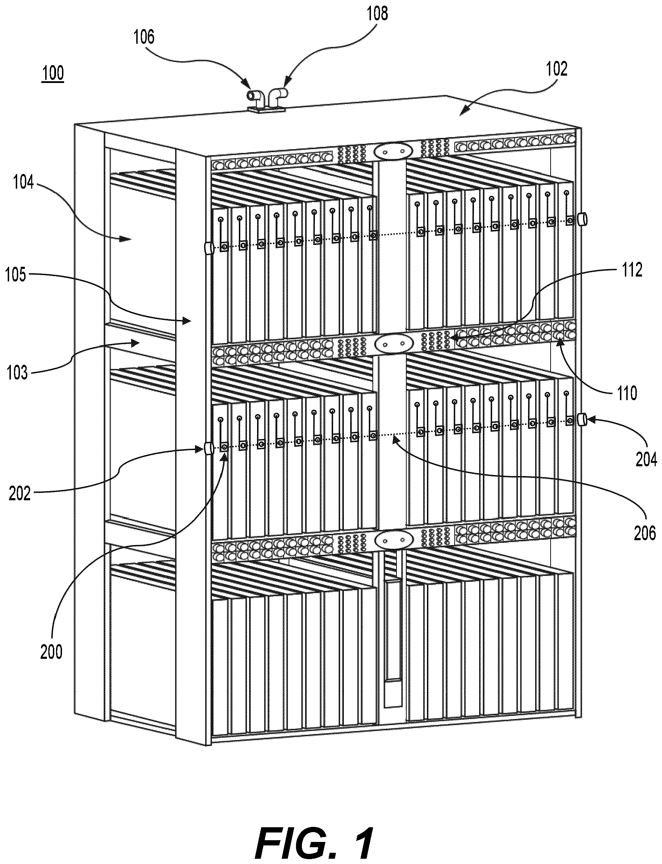

Figure 1 shows a perspective view of a rack system 100 for housing numerous rack-mounted assemblies 104 with corresponding temperature monitoring systems 200, in accordance with the embodiments of the present disclosure. As shown, the rack system 100 may include a rack frame 102, rack-mounted assemblies 104, a liquid cooling inlet conduit 106 and a liquid cooling outlet conduit 108. The rack-mounted assemblies 104 may be oriented vertically with respect to the rack frame 102, resembling books on a library shelf. This arrangement may provide for mounting a large number of such rack-mounted assemblies 104 in the rack frame 102, relative to conventional arrangements, particularly with respect to conventional arrangements of immersion-cooled rack-mounted assemblies.

Additionally, as shown, the rack system 100 may further comprise a power distribution unit (PDU) 110 and liquid coolant inlet/outlet connectors 112. It is to be noted that the rack system 100 may include other components such as heat exchangers, cables, pumps or the like, however, such components have been omitted from Figure 1 for clarity of understanding. As shown in Figure 1, the rack frame 102 may include rack shelves 103 to accommodate one or more rack-mounted assemblies 104. As noted above, the one or more rack-mounted assemblies 104 may be arranged vertically with respect to the rack shelves 103. In some embodiments, guide members (not shown) may be used on the rack shelves 103 to guide the rack-mounted assemblies 104 into position during racking and de-racking, and to provide proper spacing between the rack-mounted assemblies 104 for racking and de-racking.

As further shown in Figure 1, the rack frame 102 may also include rack posts 105 to support the rack shelves 103. Mounted on the rack posts 105 are optical transmitters 202 and optical receivers 204 of which only two of each are shown for clarity. As described more fully below, the optical transmitters 202 and optical receivers 204 are arranged to cooperate with the temperature monitoring systems 200 to indicate a location of overheated rack-mounted assemblies 104.

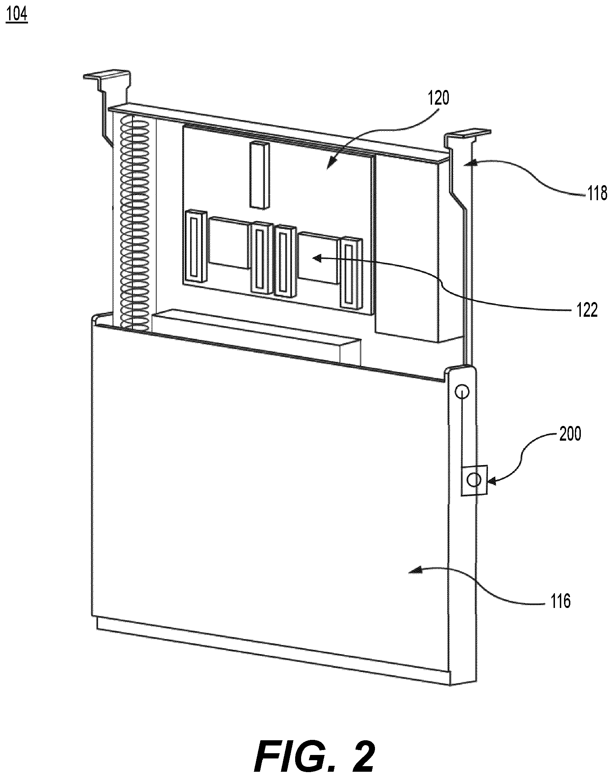

Figure 2 shows a perspective view of a rack-mounted assembly 104 with a temperature monitoring system 200, in accordance with the embodiments of the present disclosure. As shown, the rack-mounted assembly 104 includes a detachable frame, or "board" 118 of the electronic device 120, and an immersion case 116 wherein the temperature monitoring system 200 is mounted on. Preferably, the temperature monitoring system 200 is mounted on the top front face of the immersion case 116 at the level of an immersion cooling liquid (not shown) to account for thermal convection. The board 118 holds heat-generating electronic components 122 of the electronic device 120 and may be immersed in the immersion cooling liquid within the immersion case 116. Although, the immersion case 116, board 118, and electronic components 122 are shown as separate parts, it will be understood by one of ordinary skill in the art that, in some embodiments, two or more of these components could be combined. For example, the electronic components 122 could be fixed directly on the board 118 and/or the immersion case 116.

It is contemplated that the electronic devices 120 of the rack-mounted assemblies 104 may generate significant amount of heat. Consequently, the rack system 100 may use a cooling system to cool down the electronic devices 120 to prevent the electronic devices 120 from overheating and from being damaged. As described more fully below, in the event that a corresponding cooling system malfunctions, such as, for example, when a potential overheating event is detected, the temperature monitoring system 200 is able to disconnect the corresponding electronic device 120 from the power supply to protect the electronic device 120 from failure due to overheating.

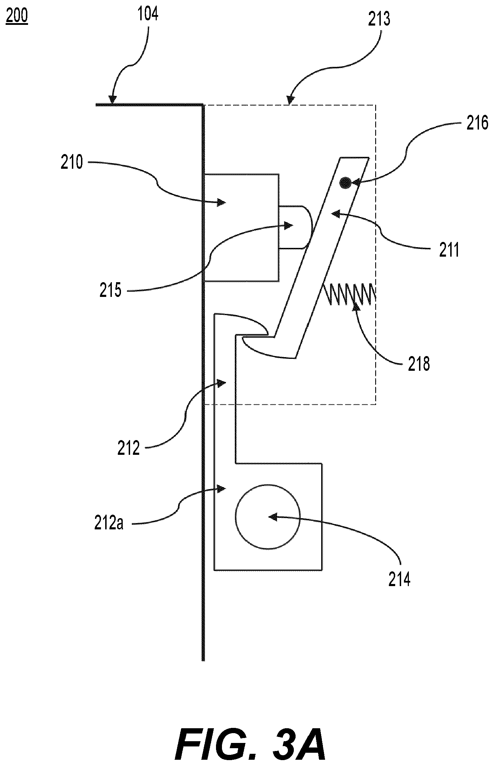

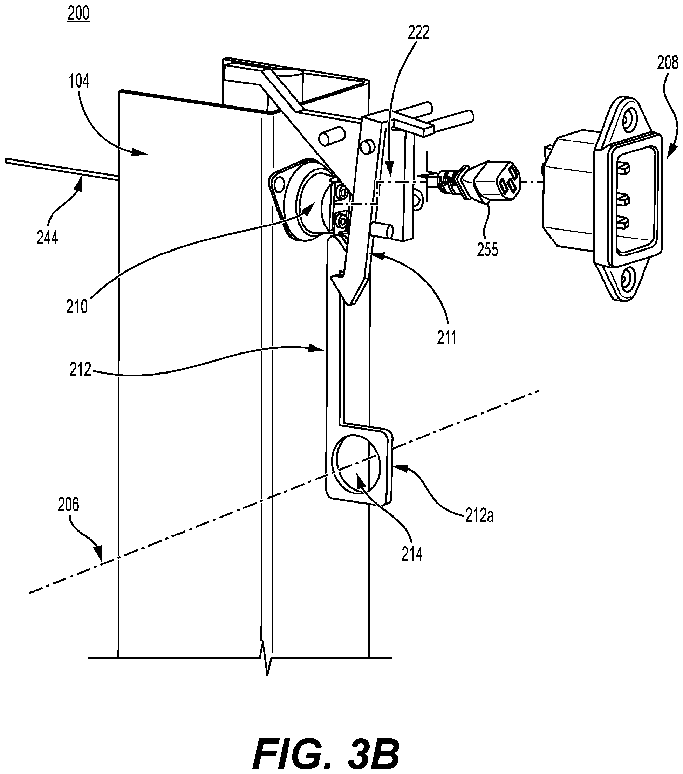

Figures 3A and 3B show an exemplary temperature monitoring system 200 for rack-mounted assemblies 104, in accordance with the embodiments of the present disclosure. As shown, for each electronic device 120, the temperature monitoring system 200 employs a thermostatic unit 210 and first and second lever elements 211, 212 that are mechanically coupled to the thermostatic unit 210. In a non-limiting example, the thermostatic unit 210 may comprise a manual reset bimetal snap-action thermostat or other similarly operational thermostatic devices.

Each thermostatic unit 210 of the temperature monitoring system 200 is mounted onto a corresponding rack-mounted assembly 104, for example, mounted on the top front face of the immersion case 116 at the level of an immersion cooling liquid as previously discussed, and is electrically connected to the PDU 110 via a PDU input 208 to receive electric power therefrom. As shown on Figure 3B, the PDU input 208 is, in use, electrically connected to the thermostatic unit 210 via an electric connection 222. More specifically, the temperature monitoring system 200 may include a receiving power inlet 255 to establish the electric connection 222. In this non-limitative implementation, the receiving power inlet 255 may be a C13 female plug for mating with the PDU input 208 that is, in this implementation, a C13 male plug. The thermostatic unit 210 is further electrically connected to the rack-mounted assembly 104 and more specifically to the electronic device 120, via an electric connection 244. Therefore, the PDU input 208 is electrically connected to the electronic device 120 via the electric connection 222, the thermostatic unit 210 and the electric connection 244, such that the thermostatic unit 210 may selectively disconnect the electronic device 120 from the PDU 110 in response to detecting a temperature of the rack-mounted assembly 104 that exceeds a high temperature threshold. It can be said that the thermostatic unit 210 provide thermal safety to the electric connection between the PDU 110 and the electronic device 120.

As mentioned previously, and indicated in Figures 3A and 3B, the first and second lever elements 211 and 212 are mechanically coupled to the thermostatic unit 210. The first lever element 211 is attached to a protective housing 213 of the temperature monitoring system 200, such as, for example, at a pivot point 216, and adjoins a button portion 215 of the thermostatic unit 210. The first lever element 211 is also configured to be in contact with and retains the second lever element 212. The second lever element 212 is configured with a lever portion 212a containing an aperture 214. As described more fully below, under normal operating conditions, the aperture 214 allows for an optical rack-mounted assembly locator beam 206 to travel therethrough. The optical rack-mounted assembly locator beam 206 originates from the optical transmitter 202 and travels to the optical receiver 204 where it is detected.

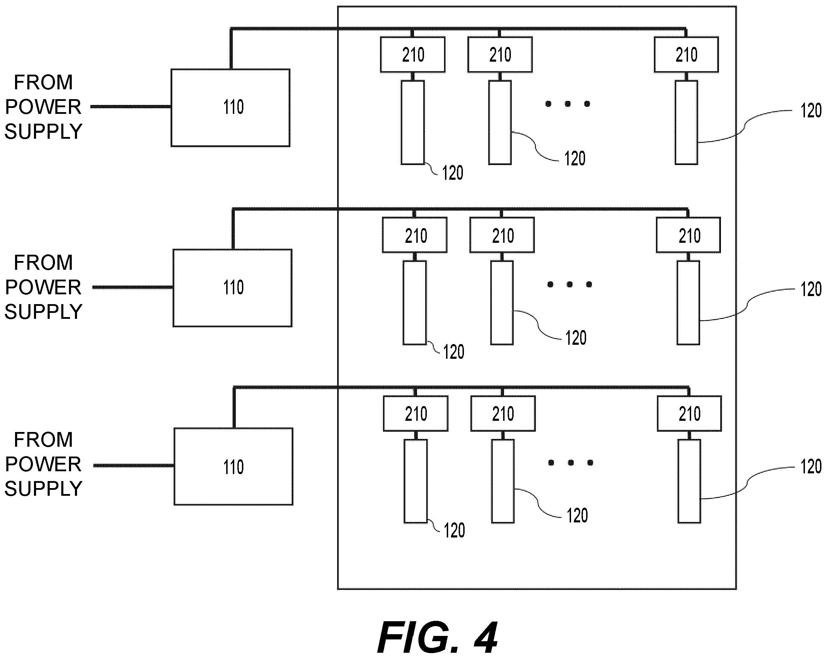

Figure 4 is a schematic diagram of the electrical connections of the temperature monitoring system 200 relative to the electronic devices 120 (e.g., servers) of the rack-mounted assemblies 104 hosted in the rack system 100, in accordance with the embodiments of the present disclosure. As shown, each electronic device 120 is electrically connected to the PDU 110 in parallel with one or more other electronic devices 120. A plurality of PDUs 110 may be used to distribute electrical power to all of the electronic devices 120 hosted in the rack system 100. In this illustrative example of Figure 4, three PDUs 110 receive electrical power from a same or different power supplies and distribute electrical power to a plurality of corresponding electronic devices 120 of the rack-mounted assemblies 104.

In turn, each electronic device 120 of the rack-mounted assembly 104 is electrically connected to a corresponding PDU 110 via a thermostatic unit 210. Each thermostatic unit 210 is configured to selectively disconnect the corresponding electronic device 120 from the PDU 110, upon detecting overheating issues based on monitored temperatures exceeding a prescribed high temperature threshold.

As noted above, each thermostatic unit 210 is configured to selectively disconnect the corresponding electronic device 120 from the PDU 110, upon detecting overheating issues based on monitored temperatures exceeding a prescribed high temperature threshold. That is, in operation, each thermostatic unit 210 is configured with two metal portions that are joined together. The two metal portions each manifest a different thermal expansion coefficient and together they form a bimetal element that bends or snaps depending on how temperature changes effect the individual metal portion thermal coefficients. With this configuration, once the thermostatic unit 210 detects a predetermined high temperature limit (e.g., high temperature threshold of approximately 50-80 degrees Celsius), the bended bimetal element of the thermostatic unit 210 operates to displace an actuator rod (not shown) to break the electrical connection between the terminals of the thermostatic unit 210. In so doing, the power supply from the PDU 110 and the corresponding rack-mounted assembly 104 is interrupted.

Simultaneously, the displaced actuator rod also dislocates the button portion 215 of the thermostatic unit 210 and the adjoining first lever element 211 rotates around the fixed pivot point 216. The rotation of the first lever element 211 also compresses a spring 218 attached to the protective housing 213 of the temperature monitoring system 200 and releases the second lever element 212, thus enable a translation of the second lever element 212 downwardly.

Under normal operating conditions, the first and second lever elements 211, 212 and the lever portion 212a of the second lever element 212 with the aperture 214 are oriented in a way that allows the optical rack-mounted assembly locator beam 206 to pass through the aperture 214. However, when the second lever element 212 is released, for example, in the event when the actuator rod of the thermostatic unit 210 is displaced, the lever portion 212a of the second lever element 212 blocks the light beam 206. When the optical rack-mounted assembly locator beam 206 impinges the lever portion 212a, the interrupted light beam 206 warns an operator that there is an issue with the associated rack system 100 and indicates the exact location of the rack-mounted assembly 104 disconnected from the PDU 110.

In some non-limiting embodiments, the optical receiver 204 is connected to a controller (not shown). When the optical rack-mounted assembly locator beam 206 is detected by the optical receiver 204, the rack system 100 is functioning properly. However, when the optical rack-mounted assembly locator beam 206 is interrupted, the optical receiver 204 does not detect any light beam. In response to the absence of the light beam, the controller may transmit an alert signal to an operator device communicably connected thereto to indicate occurrence of an anomaly to an operator of the datacenter.

In a given rack system (e.g., the rack system 100), the thermostatic unit 210 selectively disconnects the electronic device 120 from the power supply in case of a temperature anomaly, for example, when an overheating event is detected. If the temperature monitoring system 200 detects a temperature value of the rack-mounted assembly 104 exceeding a high temperature threshold, the corresponding electronic device 120 is disconnected from the power supply without impacting operation of the other electronic devices 120 in the other rack-mounted assemblies 104 of the rack system 100. For example, propagation of potential damages caused by overheating in a given electronic device 120 (e.g., server) of the datacenter is limited by the individual disconnection of the servers from the respective power supply.

In the disclosed embodiments, even if the rack-mounted assembly 104 has sufficiently cooled down, i.e., the temperature value of the rack-mounted assembly 104 is reduced below the high temperature threshold, the thermostatic unit's 210 actuator rod will remain displaced, the electrical circuit stays open, and the spring 218 continues to be in a compressed state, thereby preventing the electronic device 120 (e.g., server) from being reconnected to the power supply without operator intervention. That is, once the specific rack-mounted assembly 104 is disconnected from the PDU 110, an operator is required to manually reset the thermostatic unit 210 and the first and second lever elements 211, 212 to reconnect the rack-mounted assembly 104 to the PDU 110. For example, the operator may push the second lever element 212 upwards. By doing so, the second lever element 212 will push the first lever element 211 that will, in turn, compress the spring 218. The first and second lever elements 211, 212 will thus interlock as shown on Figure 3A.

It is to be understood that the operations and functionality of the described datacenter temperature monitoring system 200, its constituent components, and associated processes may be achieved by any one or more of hardware-based, software-based, and firmware-based elements. Such operational alternatives do not, in any way, limit the scope of the present disclosure.

It will be further understood that, although the embodiments presented herein have been described with reference to specific features and structures, various modifications and combinations may be made without departing from the disclosure. For example, it is contemplated that in some embodiments, two or more of the temperature monitoring systems described above may be used, in any combination. The specification and drawings are, accordingly, to be regarded simply as an illustration of the discussed implementations or embodiments and their principles as defined by the appended claims, and are contemplated to cover any and all modifications, variations, combinations or equivalents that fall within the scope of the present disclosure.

## Claims

1. A datacenter temperature monitoring system (200) for rack-mounted assemblies (104), comprising:
a power distribution unit (PDU, 110) configured to distribute power to each of the rack-mounted assemblies (104); and
a thermostatic unit (210) electrically connected to the PDU (110) and configured to detect a temperature of one or more of the rack-mounted assemblies (104),
wherein, in response to the thermostatic unit (210) detecting a temperature of one of the rack-mounted assemblies (104) that exceeds a high temperature threshold, the thermostatic unit (210) causes the corresponding rack-mounted assembly (104) to be disconnected from the PDU (110).

2. The datacenter temperature monitoring system (200) of claim 1, wherein the disconnecting of the corresponding rack-mounted assembly (104) from the PDU (110) is isolated to the corresponding rack-mounted assembly (104) without affecting the distribution of power to the plurality of other rack-mounted assemblies (104).

3. The datacenter temperature monitoring system (200) of claims 1 or 2, wherein the thermostatic unit (210) comprises a bimetal snap-action thermostat (210) that is mounted onto a front face of each of the rack-mounted assemblies (104).

4. The datacenter temperature monitoring system (200) of claim 3, wherein the bimetal snap-action thermostat (210) comprises two metal portions with different coefficients of thermal expansion joined together to provide a bimetal element, in which the bimetal element is configured to bend due to the different thermal expansion coefficients based on detected temperature levels.

5. The datacenter temperature monitoring system (200) of claims 3 or 4, wherein, in response to the bimetal element bending beyond a displacement threshold value due to detected temperature levels, the displacement causes the rack-mounted assembly (104) to disconnect from the PDU (110).

6. The datacenter temperature monitoring system (200) of claims 3 or 4, wherein, in response to the bimetal element bending beyond a displacement threshold value due to detected temperature levels, the displacement causes a first and second lever elements (211, 212) to dislocate and interrupt an optical rack-mounted assembly locator beam (206) to indicate a location of the rack-mounted assembly (104) disconnected from the PDU (110).

7. The datacenter temperature monitoring system (200) of claim 6, wherein the second lever element (212) comprises a lever portion (212a) having an aperture (214) that allows the optical rack-mounted assembly locator beam (206) to travel therethrough during normal operations.

8. The datacenter temperature monitoring system (200) of claim 1, wherein the rack-mounted assembly (104) requires operator intervention to manually reconnect the PDU (110) after disconnection.

9. The datacenter temperature monitoring system (200) of claim 1, wherein the high temperature threshold is set between approximately 50 and approximately 80 degrees Celsius.

10. The datacenter temperature monitoring system (200) of claim 1, wherein the rack-mounted assemblies (104) each comprise an electronic processing board (118) that is at least partially immersed in an immersion case (116) that contains an immersion cooling liquid for cooling the rack-mounted assembly (104).

11. A method of monitoring temperatures for datacenter rack-mounted assemblies (104), comprising:
distributing power by a power distribution unit (PDU, 110) to a plurality of rack-mounted assemblies (104) having thermostatic units (210) mounted thereon configured to detect a temperature of the corresponding rack-mounted assembly (104); and
in response to the thermostatic unit (210) detecting a temperature of the corresponding rack-mounted assembly (104) exceeding a high temperature threshold, the thermostatic unit (210) causing the corresponding rack-mounted assembly (104) to disconnect from the PDU (110).

12. The method of claim 11, wherein the disconnecting of the corresponding rack-mounted assembly (104) from the PDU (110) is isolated to the corresponding rack-mounted assembly (104) without affecting the distribution of power to the plurality of other rack-mounted assemblies (104).

13. The method of claims 11 or 12, wherein each thermostatic unit (210) comprises a bimetal snap-action thermostat (210) comprising two metal portions with different coefficients of thermal expansion joined together to provide a bimetal element, in which the bimetal element is configured to bend due to the different thermal expansion coefficients based on detected temperature levels.

14. The method of claim 13, wherein, in response to the bimetal element bending beyond a displacement threshold value due to detected temperature levels, the displacement causes the rack-mounted assembly (104) to disconnect from the PDU (110) and simultaneously causes a first and second lever elements (211, 212) to dislocate and interrupt an optical rack-mounted assembly locator beam (206) to indicate a location of the rack-mounted assembly (104) disconnected from the PDU (110).

15. The method of claim 11, wherein the disconnected rack-mounted assembly (104) requires operator intervention to manually reconnect the PDU (110) after disconnection.

## Amended claims

### Amended claims in accordance with Rule 137(2) EPC.

1. A datacenter temperature monitoring system (200) for rack-mounted assemblies (104), comprising:
a power distribution unit (PDU, 110) configured to distribute power to each of the rack-mounted assemblies (104);
a rack-mounted optical locator beam (206) configured to be emitted laterally across each rack housing the rack-mounted assemblies (104); and
a plurality of thermostatic units (210) electrically connected to the PDU (110) and to each of the rack-mounted assemblies (104) to detect a temperature of each of the rack-mounted assemblies (104), each of the thermostatic units comprising:
a bimetal element configured to bend based on the detected temperature exceeding a high temperature threshold;
an actuator rod mechanically coupled to the bimetal element at one end and a button portion (215) at another end, the actuator rod operative to be displaced in response to the bending of the bimetal element; and
a lever mechanism (211, 212) in contact with the button portion (215) and incorporating an aperture (214) oriented to allow passage of the optical locator beam (206) therethrough,
wherein, in response to the thermostatic unit (210) detecting that a temperature of one of the rack-mounted assemblies (104) exceeds the high temperature threshold, the actuator rod is displaced to electrically disconnect the corresponding thermostatic unit and rack-mounted assembly from the PDU (110) and the lever mechanism (211, 212) is dislocated to block the optical locator beam (206) and indicate a location of the corresponding rack-mounted assembly disconnected from the PDU.

2. The datacenter temperature monitoring system (200) of claim 1, wherein the disconnecting of the corresponding rack-mounted assembly (104) from the PDU (110) is isolated without affecting the distribution of power from the PDU to the other rack-mounted assemblies (104).

3. The datacenter temperature monitoring system (200) of claims 1 or 2, wherein the thermostatic unit (210) is mounted onto a front face of each of the rack-mounted assemblies (104).

4. The datacenter temperature monitoring system (200) of anyone of claims 1 to 3, wherein the bimetal element comprises two metal portions with different coefficients of thermal expansion joined together in which the bimetal element is configured to bend in a predetermined direction due to the different thermal expansion coefficients based on detected temperature levels.

5. The datacenter temperature monitoring system (200) of anyone of claims 1 to 4, wherein, the bimetal element bending operates to urge the actuator rod to be laterally displaced.

6. The datacenter temperature monitoring system (200) of anyone of claims 1 to 5, wherein, the lever mechanism (211, 212) comprises a first lever element (211) and a second lever element (212), in which an upper portion of the first lever element is configured to be rotatable about a fixed pivot point (216) and remain in contact with the button portion (215) and a lower portion mechanically engages the second lever element containing the aperture (214).

7. The datacenter temperature monitoring system (200) of anyone of claims 1 to 6 wherein, upon the detection of the corresponding rack-mounted assembly exceeding the high temperature threshold, the actuator rod is displaced and urges the first lever element (211) to rotate and disengage from the second lever element (212) to cause the second lever to become dislocated and block the optical locator beam (206).

8. The datacenter temperature monitoring system (200) of anyone of claims 1 to 7 wherein the rack-mounted assembly (104) requires operator intervention to manually reconnect the PDU (110) after disconnection.

9. The datacenter temperature monitoring system (200) of anyone of claims 1 to 8, wherein the high temperature threshold is set between approximately 50 and approximately 80 degrees Celsius.

10. The datacenter temperature monitoring system (200) of anyone of claims 1 to 9, wherein the rack-mounted assemblies (104) each comprise an electronic processing board (118) that is at least partially immersed in an immersion case (116) that contains an immersion cooling liquid for cooling the rack-mounted assembly (104).

11. A method of monitoring temperatures for datacenter rack-mounted assemblies (104), comprising:
providing a rack-mounted optical locator beam (206) configured to be emitted laterally across each rack housing the rack-mounted assemblies (104);
distributing power by a power distribution unit (PDU, 110) to a plurality of rack-mounted assemblies (104) having thermostatic units (210) mounted thereon that are electrically connected to the PDU and configured to detect a temperature of the corresponding rack-mounted assembly (104), each of the thermostatic units comprising:
a bimetal element configured to bend based on the detected temperature exceeding a high temperature threshold;
an actuator rod mechanically coupled to the bimetal element at one end and a button portion (215) at another end, the actuator rod operative to be displaced in response to the bending of the bimetal element; and
a lever mechanism (211, 212) in contact with the button portion (215) and incorporating an aperture (214) oriented to allow passage of the optical locator beam (206) therethrough,
wherein, in response to the thermostatic unit (210) detecting that a temperature of one of the rack-mounted assemblies (104) exceeds the high temperature threshold, displacing the actuator rod to electrically disconnect the corresponding thermostatic unit and rack-mounted assembly from the PDU (110) and dislocating the lever mechanism (211, 212) to block the optical locator beam (206) and indicate a location of the corresponding rack-mounted assembly disconnected from the PDU.

12. The method of claim 11, wherein the disconnecting of the corresponding rack-mounted assembly (104) from the PDU (110) without affecting the distribution of power from the PDU to the other rack-mounted assemblies (104).

13. The method of claims 11 or 12, wherein bimetal element comprises two metal portions with different coefficients of thermal expansion joined together, in which the bimetal element is configured to bend in a predetermined direction due to the different thermal expansion coefficients based on detected temperature levels.

14. The method of anyone of claims 11 to 13, wherein, the lever mechanism (211, 212) comprises:
a first lever element (211); and
a second lever element (212),
wherein an upper portion of the first lever element is configured to be rotatable about a fixed pivot point (216) and remain in contact with the button portion (215) and a lower portion of the first lever element mechanically engages the second lever element containing the aperture (214), and
wherein upon the detection of the corresponding rack-mounted assembly exceeds the high temperature threshold, the actuator rod is displaced and urges the first lever element (211) to rotate and disengage from the second lever element (212) to cause the second lever to become dislocated and block the optical locator beam (206).

15. The method of anyone of claims 11 to 14, wherein the disconnected rack-mounted assembly (104) requires operator intervention to manually reconnect the PDU (110) after disconnection.
